# EUROPÄISCHE PATENTSCHRIFT

(11) **EP 2 321 858 B1**
(45) Veröffentlichungstag und Bekanntmachung des Hinweises auf die Patenterteilung: **11.04.2018**
(21) Anmeldenummer: 09741191.2
(22) Anmeldetag: 06.08.2009
(51) Int. Cl.: H01L 33/44

(54) **OPTOELEKTRONISCHES BAUELEMENT UND VERFAHREN ZU DESSEN HERSTELLUNG**
OPTOELECTRONIC COMPONENT AND METHOD FOR THE PRODUCTION THEREOF
COMPOSANT OPTOÉLECTRONIQUE ET SON PROCÉDÉ DE FABRICATION

(30) Priorität: 12.08.2008 DE 102008038750
(43) Veröffentlichungstag der Anmeldung: 18.05.2011
(73) Patentinhaber: OSRAM Opto Semiconductors GmbH, 93055 Regensburg (DE)
(72) Erfinder: WEIMAR, Andreas, 93055 Regensburg (DE)
(74) Vertreter: Epping - Hermann - Fischer
(86) Internationale Anmeldenummer: PCT/DE2009/001115
(87) Internationale Veröffentlichungsnummer: WO 2010/017807

(56) Entgegenhaltungen:
- EP-A- 0 905 797
- EP-A- 1 592 070
- WO-A-01/82384
- WO-A-02/13281
- WO-A-03/038913
- WO-A2-2004/032247
- US-A1- 2004 259 278
- US-A1- 2005 269 702
- US-B1- 6 455 878
- SCHNITZER I ET AL: "30% EXTERNAL QUANTUM EFFICIENCY FROM SURFACE TEXTURED, THIN-FILM LIGHT-EMITTING DIODES" APPLIED PHYSICS LETTERS, AIP, AMERICAN INSTITUTE OF PHYSICS, MELVILLE, NY, US, Bd. 63, Nr. 16, 18. Oktober 1993 (1993-10-18), Seiten 2174-2176, XP000404433 ISSN: 0003-6951

## Beschreibung

Es wird ein optoelektronisches Bauelement nach dem Anspruch 1 sowie Verfahren nach dem Anspruch 7 zu dessen Herstellung angegeben.

Ein weit verbreitetes Problem von optoelektronischen Bauelementen, welche eine Passivierungsschicht aufweisen, ist, dass Beschädigungen wie beispielsweise Risse, welche sich in einem Teil der Passivierungsschicht ausbilden, sich diese über die gesamte Passivierungssicht fortsetzen können. So können sich beispielsweise Risse ausbilden, wenn viele auf einem gemeinsamen Substrat angeordnete und durch Trenngräben im Substrat voneinander abgetrennte optoelektronische Bauelemente durch z. B. Sägen vereinzelt werden. Diese Risse im Trenngraben können sich bis zur Halbleiterschicht fortsetzen und unter anderem zu einer beschleunigten Alterung aufgrund eindringender Feuchte führen. Feuchtigkeit kann durch diese Risse hindurch in die Halbleiterschicht gelangen und dort zum Kurzschluss des Bauelements führen.

Dokument WO02/13281 A1 offenbart ein Dünnfilm optoelektronisches Bauelement umfassend: einen Träger, eine metallische Spiegelschicht angeordnet auf dem Träger, eine erste Passivierungsschicht angeordnet auf einem Bereich der metallischen Spiegelschicht, eine Halbleiterschicht zur Erzeugung einer im elektrischen Betrieb aktiven Zone angeordnet auf der ersten Passivierungsschicht, eine zweite Passivierungsschicht, welche auf einem ersten Bereich auf der Oberseite der Halbleiterschicht angeordnet ist.

Eine Aufgabe von Ausführungsformen der Erfindung besteht darin, ein optoelektronisches Bauelement bereitzustellen, dessen Passivierungsschicht im Bereich der Halbleiterschicht einen verbesserten Schutz aufweist.

Die Aufgabe wird durch ein optoelektronisches Bauelement nach dem Anspruch 1 gelöst. Weitere Ausführungsformen des optoelektronischen Bauelements sowie Verfahren zur Herstellung des optoelektronischen Bauelements sind Gegenstand weiterer Patentansprüche.

Eine Ausführungsform der Erfindung betrifft ein optoelektronisches Bauelement umfassend einen Träger, eine metallische Spiegelschicht angeordnet auf dem Träger, eine erste Passivierungsschicht angeordnet auf einem Bereich der metallischen Spiegelschicht, eine Halbleiterschicht zur Erzeugung einer im elektrischen Betrieb aktiven Zone, angeordnet auf der ersten Passivierungsschicht, eine zweite Passivierungsschicht umfassend zwei Bereiche, wobei der erste Bereich auf der Oberseite der Halbleiterschicht angeordnet ist, und der zweite Bereich auf der metallischen Spiegelschicht, welcher frei von der Halbleiterschicht ist, wobei der erste Bereich und der zweite Bereich der zweiten Passivierungsschicht durch einen um die erste Passivierungsschicht umlaufenden Bereich, der frei von der zweiten Passivierungsschicht ist, voneinander getrennt sind.

Dadurch dass in dem optoelektronischen Bauelement die zweite Passivierungsschicht, welche sich auf der Oberfläche des optoelektronischen Bauelements befindet, in zwei Teilbereiche untergliedert ist, welche voneinander getrennt sind, können sich keine Risse oder andere mechanische Defekte von dem einen Bereich in den anderen Bereich fortsetzen. Unter voneinander getrennt ist im Zusammenhang mit dieser Erfindung vor allem zu verstehen, dass die beiden Bereiche der zweiten Passivierungsschicht keinen direkten mechanischen Kontakt zueinander haben über den beispielsweise eine Fortpflanzung eines Risses erfolgen könnte. Der zweite Bereich der zweiten Passivierungsschicht ist hierbei unter anderem auf dem Bereich angeordnet, in dem es bei dem Vereinzelungsprozess im Herstellungsverfahren zu starken mechanischen Belastungen kommen kann. Die Vereinzelung der einzelnen Bauelemente kann beispielsweise durch Sägen erfolgen, wodurch es zu Rissen im zweiten Bereich der zweiten Passivierungsschicht oder auch in den darunter liegenden Schichten kommen kann. Aus den darunter liegenden Schichten können sich die Risse in den zweiten Bereich der zweiten Passivierungsschicht fortsetzen. Der erste Bereich der zweiten Passivierungsschicht hingegen befindet sich auf der Oberfläche der Halbleiterschicht. Dadurch dass der erste und zweite Bereich der zweiten Passivierungsschicht keinen mechanischen Kontakt zueinander aufweisen, können sich Risse, welche sich im zweiten Bereich der zweiten Passivierungsschicht gebildet haben, nun nicht in den ersten Bereich der zweiten Passivierungsschicht hin fortsetzen. Die Halbleiterschicht und der erste Bereich der zweiten Passivierungsschicht werden somit trotz mechanischer Belastung angrenzender Bereiche nicht beschädigt. Somit können durch den ersten Bereich der zweiten Passivierungsschicht keine Feuchtigkeit oder andere störende Umwelteinflüsse in die Halbleiterschicht eindringen. Dadurch wird die Lebensdauer des Bauelements deutlich gesteigert.

In einer weiteren Ausführungsform des optoelektronischen Bauelements sind die erste Passivierungsschicht und die zweite Passivierungsschicht räumlich voneinander getrennt.

Unter räumlicher Trennung ist vor allem zu verstehen, dass zwischen der ersten Passivierungsschicht und der zweiten Passivierungsschicht kein direkter mechanischer Kontakt besteht, über den sich beispielsweise ein Riss fortsetzen könnte. Dadurch ist eine Rissausbreitung ausgehend vom zweiten Bereich der ersten Passivierungsschicht auch nicht über die erste Passivierungsschicht möglich. Somit kann sich ein Riss der sich beispielsweise im zweiten Bereich der zweiten Passivierungsschicht ausbildet nicht über die erste Passivierungsschicht hin zum ersten Bereich der zweiten Passivierungsschicht fortsetzen. Dies hat zur Folge, dass nicht nur der erste Bereich der zweiten Passivierungsschicht, sondern auch die erste Passivierungsschicht nicht durch Fortsetzung von Rissen oder anderen mechanischen Beschädigungen, welche im zweiten Bereich der zweiten Passivierungsschicht auftreten, beschädigt werden können. Die Halbleiterschicht ist somit auch von ihrer Unterseite her gegenüber Beschädigungen geschützt.

In einer Ausführungsform des optoelektronischen Bauelements weist die Halbleiterschicht in Bezug auf die erste Passivierungsschicht überhängende Kanten auf.

Das bedeutet, dass die erste Passivierungsschicht in dem Bereich der überhängenden Kanten der Halbleiterschicht unterhalb der Kanten verläuft und die Halbleiterschicht über die erste Passivierungsschicht hinausragt. Die Kanten überschatten also die erste Passivierungsschicht. Dadurch kann beispielsweise vermieden werden, dass sich zwischen der zweiten Passivierungsschicht, deren erster Bereich sich über die Halbleiterschicht erstreckt, und der ersten Passivierungsschicht ein direkter mechanischer Kontakt ausbildet. Des Weiteren wird vermieden, dass zwischen der ersten Passivierungsschicht und dem zweiten Bereich der zweiten Passivierungsschicht beim Aufbringen der zweiten Passivierungsschicht ein mechanischer Kontakt ausgebildet wird. Aus dem Überhang der Hableiterschicht bezüglich der ersten Passivierungsschicht ergibt sich für das Herstellungsverfahren ein weiterer Vorteil. So kann durch die Ausformung mit den überhängenden Kanten die zweite Passivierungsschicht großflächig über das Bauelement aufgetragen werden, wobei diese an den überhängenden Kanten von alleine abreißt, so dass sich ein erster Bereich und ein zweiter Bereich der zweiten Passivierungsschicht ohne die Notwendigkeit eines strukturierten Auftragens ausbildet. Durch das Abreißen der zweiten Passivierungsschicht gibt es keine mechanische Verbindung mehr zwischen dem ersten Bereich und dem zweiten Bereich der zweiten Passivierungsschicht.

In einer weiteren Ausführungsform des optoelektronischen Bauelements ist die erste Passivierungsschicht im Bereich der überhängenden Kanten unterbrochen, so dass ein Bereich ausgebildet ist, der frei von der ersten Passivierungsschicht ist.

Bei dieser Ausführungsform wurde nicht die gesamte erste Passivierungsschicht, welche durch die Strukturierung der Halbleiterschicht freigelegt wurde, entfernt, sondern nur ein Teil der ersten Passivierungsschicht, so dass in der ersten Passivierungsschicht, welche zumindest teilweise unter der Halbleiterschicht liegt, ein umlaufender Bereich ausgebildet wurde, der den Bereich unter der Halbleiterschicht von der restlichen ersten Passivierungsschicht abtrennt. Unter Abtrennen ist insbesondere zu verstehen, dass keine mechanische Verbindung zwischen den verschiedenen Teilen der ersten Passivierungsschicht besteht, so dass sich ein Riss, welcher sich in dem Bereich der ersten Passivierungsschicht ausgebildet hat, der nicht in Kontakt mit der Halbleiterschicht steht, oder aber auch im zweiten Bereich der zweiten Passivierungsschicht ausgebildet hat, sich nicht in den Bereich der ersten Passivierungsschicht fortsetzen kann, welcher in direktem Kontakt mit der Halbleiterschicht steht.

In einer weiteren Ausführungsform weist das optoelektronische Bauelement keine erste Passivierungsschicht mehr in dem Bereichen auf, in denen keine Halbleiterschicht vorhanden ist. Nach dem Strukturieren oder beim Strukturieren der Halbleiterschicht wurde somit die dadurch freigelegte erste Passivierungsschicht vollständig entfernt.

In einer weiteren Ausführungsform des optoelektronischen Bauelements weist die Halbleiterschicht seitliche Mesaflanken auf.

Je nachdem, welche Technik zur Strukturierung der Halbleiterschicht angewandt wird, weisen die Mesaflanken eine stärkere oder weniger starke Neigung auf. Die Mesaflanken können ebenso wie die Oberseite der Halbleiterschicht von der zweiten Passivierungsschicht bedeckt sein. Die zweite Passivierungsschicht, welche auf den Mesaflanken angeordnet ist, ist somit ein Teil des ersten Bereiches der zweiten Passivierungsschicht. Die Halbleiterschicht wird somit auf der Oberseite wie auch an ihren Seitenflächen von dem ersten Bereich der zweiten Passivierungsschicht umgeben und durch diese geschützt.

In einer Ausführungsform des optoelektronischen Bauelements ist dieses als Dünnfilm-LED-Chip ausgeformt.

Ein Dünnfilm-LED-Chip zeichnet sich durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-LED-Chip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 um oder weniger, insbesondere im Bereich von 10 um oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-LED-Chips ist beispielsweise in der Druckschrift I. Schnitzer et al., Appl. Phys. Lett. 63 (16) 18. Oktober 1993, Seiten 2174 - 2176 beschrieben, deren Offenbarungsgehalt insofern hiermit durch Rückbezug aufgenommen wird. Beispiele für Dünnfilm-LED-Chips sind in den Druckschriften EP 0905797 A2 und WO 02/13281 A1 beschrieben, deren Offenbarungsgehalt insofern hiermit ebenfalls durch Rückbezug aufgenommen wird.

Vorzugsweise weist das fertige Bauelement kein Substrat mehr auf.

Neben dem optoelektronischen Bauelement selbst werden auch Verfahren zu dessen Herstellung beansprucht.

Eine Verfahrensvariante zur Herstellung eines optoelektronischen Bauelements umfassen die Verfahrensschritte: Bereitstellen einer Schichtenanordnung umfassend einen Träger, eine metallische Spiegelschicht, eine erste Passivierungsschicht und eine Hableiterschicht als Verfahrensschritt A), Entfernen eines Teils der ersten Passivierungsschicht als Verfahrensschritt B), Aufbringen einer zweiten Passivierungsschicht auf der Oberseite der Halbleiterschicht und auf der metallischen Spiegelschicht, wobei ein erster Bereich der zweiten Passivierungsschicht auf der Oberseite der Halbleiterschicht und ein zweiter Bereich der zweiten Passivierungsschicht auf der Spiegelschicht erzeugt wird, und ein um die erste Passivierungsschicht umlaufender Bereich, der frei von der zweiten Passivierungsschicht ist und den ersten Bereich und den zweiten Bereich voreinander trennt, ausgebildet wird, als Verfahrensschritt C).

Die erste Passivierungsschicht wird im Verfahrensschritt B) so weit entfernt, dass bei dem nachfolgenden Aufbringen im Verfahrensschritt C) der zweiten Passivierungsschicht ein erster Bereich und ein zweiter Bereich ausgebildet werden. Durch das teilweise Entfernen der ersten Passivierungsschicht im Verfahrensschritt B) gibt es zwischen dem ersten Bereich und dem zweiten Bereich der zweiten Passivierungsschicht keine mechanische Verbindung, so dass ein Riss oder eine andere mechanische Beschädigung, welche sich in einem der beiden Bereiche ausbildet, sich nicht in dem anderen Bereich fortsetzen kann. Durch das Entfernen eines Teils der ersten Passivierungsschicht wird um den Teil der ersten Passivierungsschicht, welcher in direktem Kontakt mit der Halbleiterschicht steht, ein Bereich ausgebildet. Dieser ist frei von der ersten Passivierungsschicht. Durch diesen freien Bereich ist der erste Bereich der zweiten Passivierungsschicht vom zweiten Bereich räumlich getrennt. Eine Ausbreitung von beispielsweise Rissen, welche sich im zweiten Bereich der zweiten Passivierungsschicht ausbilden ist somit nicht über den freien Bereich hinweg möglich.

In einer weiteren Verfahrensvariante umfasst der Verfahrensschritt A) die folgenden Teilverfahrensschritte: Bereitstellen eines Substrates als Teilverfahrensschritt A1), Aufwachsen einer Halbleiterschicht, zur Erzeugung einer im elektrischen Betrieb aktiven Zone auf dem Substrat als Teilverfahrensschritt A2), Aufbringen einer ersten Passivierungsschicht auf die Halbleiterschicht, als Teilverfahrensschritt A3), Aufbringen einer metallischen Spiegelschicht auf die erste Passivierungsschicht als Teilverfahrensschritt A4), Aufsetzen eines Trägers auf die metallische Spiegelschicht als Teilverfahrensschritt A5), Lösen des Substrates von der Halbleiterschicht als Teilverfahrensschritt A6) sowie Strukturieren der Halbleiterschicht als Teilverfahrensschritt A7).

Über die Teilverfahrensschritte A1) bis A7) kann eine Schichtanordnung gefertigt werden, wie sie im Verfahrensschritt A) bereitgestellt wird. Diese umfasst einen Träger, eine auf dem Träger angeordnete metallische Spiegelschicht, eine erste auf der metallischen Spiegelschicht angeordnete Passivierungsschicht und auf der ersten Passivierungsschicht angeordnet eine strukturierte Halbleiterschicht.

In einer weiteren Verfahrensvariante wird durch das Strukturieren im Teilverfahrensschritt A7) in der Halbleiterschicht eine Mesa ausgebildet, wobei die Halbleiterschicht nach dem Strukturieren seitliche Mesaflanken aufweist.

Das Strukturieren der Halbleiterschicht im Teilverfahrensschritt A7) kann beispielsweise über einen Ätzschritt erfolgen. In die Halbleiterschicht werden Mesagräben geätzt, so dass die Halbleiterschicht jetzt seitliche Mesaflanken aufweist. Abhängig von der Technik welche zur Strukturierung der Halbleiterschicht eingesetzt wird, weisen die Mesaflanken eine größere oder weniger große Neigung auf. In dieser Verfahrensvariante wird im Verfahrensschritt C) die zweite Passivierungsschicht auch auf die Mesaflanken aufgebracht. Die zweite Passivierungsschicht auf der Oberfläche der Halbleiterschicht sowie die zweite Passivierungsschicht auf den Mesaflanken der Halbleiterschicht bilden zusammen den ersten Bereich der zweiten Passivierungsschicht aus.

In einer weiteren Verfahrensvariante erfolgt das Aufbringen der zweiten Passivierungsschicht im Verfahrensschritt C) so, dass die erste Passivierungsschicht und die zweite Passivierungsschicht räumlich voneinander getrennt sind.

Bei dieser Verfahrensvariante wird im Verfahrensschritt B) zumindest der gesamte Teil der ersten Passivierungsschicht entfernt, welcher nicht in direkten Kontakt mit der Halbleiterschicht steht. Dadurch, dass zwischen der ersten und der zweiten Passivierungsschicht keine mechanische Verbindung besteht, kann eine Beschädigung wie beispielsweise ein Riss, welcher im zweiten Bereich der ersten Passivierungsschicht entsteht, sich nicht in die erste Passivierungsschicht fortsetzen.

In einer weiteren Verfahrensvariante wird die erste Passivierungsschicht im Verfahrensschritt B) so entfernt, dass in der Halbleiterschicht im Bezug auf die erste Passivierungsschicht überhängende Kanten erzeugt werden.

In dieser Verfahrensvariante wird auch ein Teil der ersten Passivierungsschicht entfernt, welcher unterhalb der bereits strukturierten Halbleiterschicht angeordnet ist. Das kann beispielsweise durch einen Ätzprozess erfolgen. Hierbei würde die Halbleiterschicht somit teilweise unterätzt werden.

Durch die überhängenden Kanten der Halbleiterschicht kann die zweite Passivierungsschicht im Verfahrensschritt C) großflächig über das gesamte Bauelement aufgetragen werden, wobei die zweite Passivierungsschicht an der überhängenden Kante abreißt, und sich somit die räumlich getrennten Bereiche der zweiten Passivierungsschicht ausbilden. Es werden ein erster Bereich ausgebildet, welcher auf der Oberfläche der Halbleiterschicht und auf den Mesaflanken der Halbleiterschicht angeordnet ist, sowie ein zweiter Bereich, welcher auf der metallischen Spiegelschicht, welche frei von der ersten Halbleiterschicht ist, angeordnet ist. Die überhängenden Kanten ermöglichen es des Weiteren die zweite Passivierungsschicht großflächig aufzutragen ohne dass ein räumlicher Kontakt zur ersten Passivierungsschicht entsteht. Ein Einsatz von Masken oder Schablonen ist hierbei nicht erforderlich.

In einer Verfahrensvariante wird im Verfahrensschritt B) ein nasschemisches Verfahren verwendet.

Bei dem nasschemischen Verfahren kann beispielsweise eine Säure oder Lauge verwendet werden. Das nasschemische Verfahren ermöglicht es, auch Teile der ersten Passivierungsschicht zu entfernen, welche nicht freiliegen oder welche nicht direkt zugänglich sind und sich unterhalb der bereits strukturierten Halbleiterschicht befinden. Es können über das nasschemische Verfahren auch Teile der ersten Passivierungsschicht entfernt werden, welche beispielsweise durch einen Ionenstrahl nicht erreicht werden könnten.

In einer weiteren Variante wird das nasschemische Verfahren zum Entfernen eines Teils der ersten Passivierungsschicht verwendet, welcher unterhalb der strukturierten Halbleiterschicht angeordnet ist.

Die Halbleiterschicht wird also unterätzt. Durch das Verwenden eines nasschemischen Verfahrens kann die Halbleiterschicht deutlich weiter unterätzt werden, als mit einem physikalischen Verfahren. Bei einem physikalischen Ätzverfahren könnte die Halbleiterschicht gar nicht oder nur sehr leicht unterätzt werden. Inwieweit die Halbleiterschicht unterätzt wird kann beispielsweise über die Einwirkzeit der verwendeten Ätzlösung gesteuert werden. Ein weiterer Faktor über den das Maß der Unterätzung gesteuert werden kann ist die Konzentration der verwendeten Ätzlösung. Durch ein großflächiges Aufbringen der Ätzlösung erfolgt neben dem Unterätzen der Halbleiterschicht auch ein Entfernen derjenigen Bereiche der ersten Passivierungsschicht, welche nach dem Strukturieren der Halbleiterschicht nicht im direkten Kontakt mit der Halbleiterschicht stehen. Durch ein gezieltes lokales Aufbringen der Ätzlösung kann aber auch nur ein Bereich der ersten Passivierungsschicht entfernt werden, welcher den Teil der ersten Passivierungsschicht umläuft der im direkten Kontakt mit der Halbleiterschicht steht. Dieser umlaufende Bereich verläuft hierbei zumindest teilweise unter der Halbleiterschicht. Für den Fall, dass die erste Passivierungsschicht SiO₂ umfasst eignet sich beispielsweise gepufferte Flußsäure als Ätzlösung. Die Ätzlösung ist vorzugsweise so gewählt, dass weder die metallische Spiegelschicht noch die Halbleiterschicht von ihr angegriffen werden.

In einer weiteren Verfahrensvariante wird im Verfahrensschritt B) die gesamte erste Passivierungsschicht entfernt, welche nach der Strukturierung der Halbleiterschicht freigelegt ist.

Diese kann beispielsweise über ein nasschemisches Verfahren geschehen, bei dem die Ätzlösung großflächig aufgetragen wird.

In einer weiteren Verfahrensvariante erfolgt das Aufbringen der zweiten Passivierungsschicht im Verfahrensschritt C) großflächig, wobei der großflächige Film an den überhängenden Kanten abreißt, wodurch der erste Bereich und der zweite Bereich der zweiten Passivierungsschicht ausgebildet werden.

Das Material der zweiten Passivierungsschicht wird also nicht lokal aufgetragen. Beim Auftragen kommen weder Masken noch Schablonen zum Einsatz.

In einer Variante des Verfahrens wird im Teilverfahrensschritt A3) für die erste Passivierungsschicht ein Material verwendet, das ausgewählt ist aus: SiO₂, SiN, Al₂O₃.

Hierbei ist SiO₂ bevorzugt. SiO₂ eignet sich besonders gut zur Passivierung von optoelektronischen Bauelementen unter anderem auf Grund ihrer guten Stabilität gegenüber Strahlung.

Im Folgenden sollen Varianten der Erfindung anhand von Figuren und Ausführungsbeispielen näher erläutert werden.

Es zeigen:
- Figur 1: eine schematische Seitenansicht einer Ausführungsform eines optoelektronischen Bauelements,
- Figur 2: eine schematische Aufsicht einer Ausführungsform eines optoelektronischen Bauelements,
- Figur 3: eine schematische Seitenansicht einer weiteren Ausführungsform eines optoelektronischen Bauelements,
- Figur 4: eine schematische Seitenansicht einer weiteren Ausführungsform eines optoelektronischen Bauelements, welche zusätzlich eine Sperrschicht umfasst,
- Figur 5: eine schematische Seitenansicht einer weiteren Ausführungsform eines optoelektronischen Bauelements, welche zusätzlich noch eine Haftschicht umfasst,
- Figur 6: eine schematische Seitenansicht einer weiteren Ausführungsform eines optoelektronischen Bauelements, welche zusätzlich noch einen Kontakt umfasst,
- Figuren 7a bis 7h: jeweils schematische Seitenansichten von verschiedenen Verfahrensschritten eines Herstellungsverfahrens einer Ausführungsform des optoelektronischen Bauelements,
- Figur 8: eine schematische Seitenansicht dreier Bauelemente, welche noch nicht vereinzelt wurden.

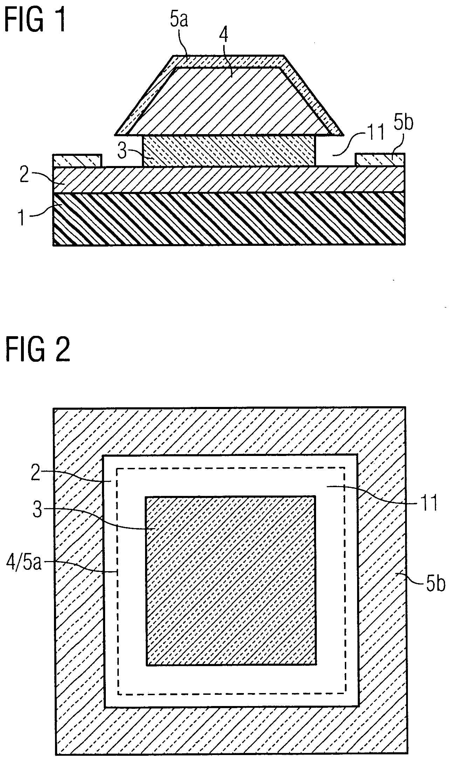

Figur 1 zeigt eine schematische Seitenansicht einer Ausführungsform des optoelektronischen Bauelements. Diese umfasst einen Träger 1. Auf dem Träger 1 ist eine metallische Spiegelschicht 2 angeordnet. Im mittleren Bereich der metallischen Spiegelschicht 2 ist eine strukturierte erste Passivierungsschicht 3 angeordnet. Auf der ersten Passivierungsschicht 3 ist eine strukturierte Halbleiterschicht 4 angeordnet, welche Mesaflanken aufweist. Die Halbleiterschicht 4 weist überhängende Kanten in Bezug auf die darunter befindliche erste Passivierungsschicht 3 auf. Auf der Oberseite der Halbleiterschicht 4 und auf den Mesaflanken der Halbleiterschicht ist der erste Bereich 5a der zweiten Passivierungsschicht angeordnet. Um die erste Passivierungsschicht 3 läuft ein Bereich 11, der frei von der zweiten Passivierungsschicht 5 ist. Der umlaufende Bereich 11 verläuft teilweise unter der Halbleiterschicht 4 und umgibt diese. Auf den umlaufenden Bereich 11 folgt an den Rändern auf der metallischen Spiegelschicht 2 der zweite Bereich 5b der zweiten Passivierungsschicht. Wie in der Figur 1 zu erkennen ist, besteht kein mechanischer Kontakt zwischen dem ersten Bereich 5a und dem zweiten Bereich 5b der zweiten Passivierungsschicht. Des Weiteren ist in Figur 1 zu sehen, dass weder der erste Bereich 5a noch der zweite Bereich 5b der zweiten Passivierungsschicht im mechanischen Kontakt mit der ersten Passivierungsschicht 3 stehen. Ein mechanischer Defekt, wie beispielsweise ein Riss, kann im zweiten Bereich 5b der zweiten Passivierungsschicht zum Beispiel beim Vereinzeln von mehreren auf einem gemeinsamen Träger angeordneten Bauelementen mittels Durchtrennens des zweiten Bereichs 5b der zweiten Passivierungsschicht und der darunter befindlichen Spiegelschicht und des Trägers entstehen. Dieser Riss kann sich aufgrund des fehlenden mechanischen Kontakts weder in die erste Passivierungsschicht 3 noch in den ersten Bereich 5a der zweiten Passivierungsschicht fortsetzen. Der erste Bereich 5a der zweiten Passivierungsschicht bliebe somit auch dann unversehrt, wenn es zur Beschädigung des zweiten Bereiches 5b der zweiten Passivierungsschicht kommt.

Figur 2 zeigt die schematische Aufsicht der in Fig. 1 im Querschnitt gezeigten Ausführungsform eines optoelektronischen Bauelements. In Figur 2 ist die metallische Spiegelschicht 2 im Bereich des umlaufenden Bereichs 11 zu sehen, die auf einer Seite vom zweiten Bereich 5b der zweiten Passivierungsschicht befindet. Auf der der metallischen Spiegelschicht 2 ist unterhalb der strukturierten hier aus Gründen der Übersichtlichkeit nicht gezeigten Halbleiterschicht 4 die erste Passivierungsschicht 3 angeordnet. Durch die gestrichelte Linie um die erste Passivierungsschicht 3 ist die Position der überhängenden Kanten der ansonsten hier nicht gezeigten Halbleiterschicht 4 angedeutet, welche sich auf der ersten Passivierungsschicht 3 befindet und in Bezug auf die erste Passivierungsschicht 3 überhängende Kanten aufweist. Auf der Halbleiterschicht 4 ist noch der erste Bereich 5a der zweiten Passivierungsschicht angeordnet. In Figur 2 ist zu sehen, dass es zwischen dem ersten Bereich 5a der zweiten Passivierungsschicht, welcher durch die gestrichelte Linie begrenzt ist, und dem außen verlaufenden zweiten Bereich 5b der zweiten Passivierungsschicht keinen mechanischen Kontakt gibt. Die beiden Bereiche 5a/5b der zweiten Passivierungsschicht liegen voneinander räumlich getrennt vor.

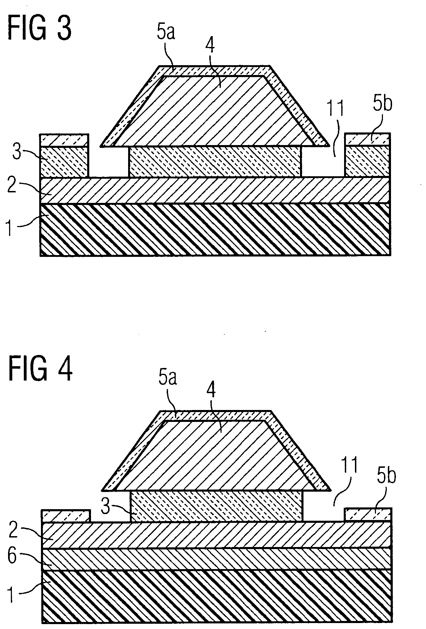

Figur 3 zeigt eine schematische Seitenansicht einer weiteren Ausführungsform des optoelektronischen Bauelements. Der Aufbau entspricht weitgehend der Ausführungsform wie sie in Figur 1 dargestellt ist. Jedoch weist diese Ausführungsform zwischen dem zweiten Bereich 5b der zweiten Passivierungsschicht und der metallischen Spiegelschicht 2 noch die erste Passivierungsschicht 3 auf. Der umlaufende Bereich 11 wird somit in dieser Ausführungsform zu beiden Seiten hin von der ersten Passivierungsschicht 3 begrenzt. Der laufenden Bereich 11 ist in dieser Ausführungsform somit wie ein umlaufender Graben in der ersten Passivierungsschicht 3 ausgeformt. Eine solche Ausführungsform kann beispielsweise durch ein lokales Entfernen der ersten Passivierungsschicht 3 erhalten werden.

Figur 4 zeigt eine schematische Seitenansicht einer weiteren Ausführungsform des optoelektronischen Bauelements. Diese Ausführungsform entspricht weitgehend der Ausführungsform wie sie in Figur 1 dargestellt ist. Sie enthält jedoch zusätzlich zwischen dem Träger 1 und der metallischen Spiegelschicht 2 eine Sperrschicht 6. Diese Sperrschicht 6 kann beispielsweise die Wanderung von Ionen aus der metallischen Spiegelschicht 2 in den Träger 1 verhindern. Für die Sperrschicht 6 eignet sich beispielsweise TiWN.

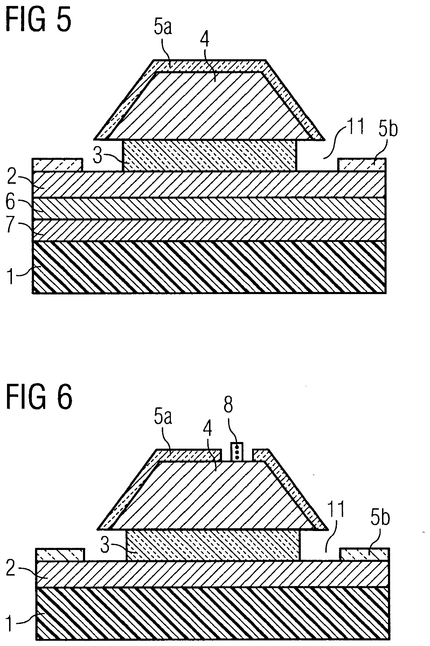

Figur 5 zeigt eine schematische Seitenansicht einer weiteren Ausführungsform des optoelektronischen Bauelements. Diese Ausführungsform entspricht weitgehend der Ausführungsform wie sie in Figur 4 dargestellt ist. Die in Figur 5 dargestellte Ausführungsform enthält jedoch zusätzlich eine Haftschicht 7, welche zwischen dem Träger 1 und der Sperrschicht 6 angeordnet ist. Diese Haftschicht 7 dient zur besseren Haftung des Trägers 1 an der Sperrschicht 6.

Figur 6 zeigt eine schematische Seitenansicht einer weiteren Ausführungsform des optoelektronischen Bauelements. Diese Ausführungsform entspricht weitgehend der Ausführungsform wie sie in Figur 1 dargestellt ist. Die in Figur 6 dargestellte Ausführungsform umfasst jedoch zusätzlich einen elektrischen Kontakt 8 der sich auf der Oberseite der Halbleiterschicht 4 befindet. Über den elektrischen Kontakt 8 kann beispielsweise über einen Bonddraht die elektrische Kontaktierung des Bauelements erfolgen. Eine weitere elektrische Kontaktierung kann beispielsweise über den Träger 1 erfolgen.

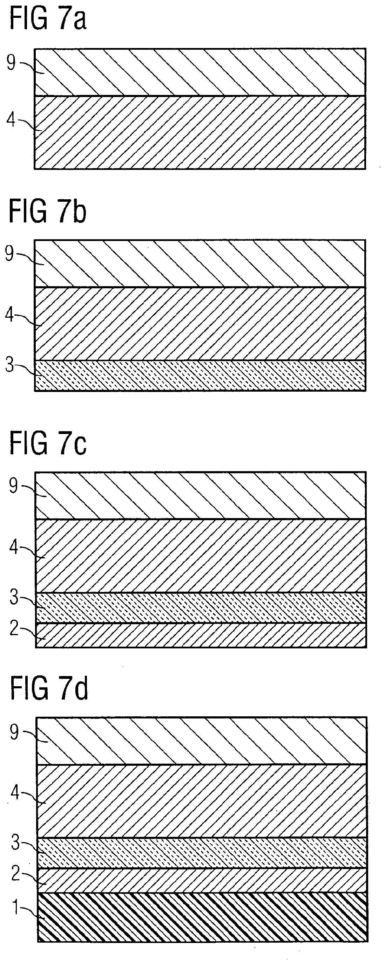

Die Figuren 7a bis 7h zeigen jeweils in einer schematischen Seitenansicht verschiedene Verfahrensstufen eines Herstellungsverfahrens für eine Ausführungsform des optoelektronischen Bauelements.

Figur 7a zeigt ein Substrat 9 auf dem eine Halbleiterschicht 4 angeordnet ist. Die Halbleiterschicht 4 kann beispielsweise wie im Teilverfahrensschritt A2) beschrieben ist, durch ein Aufwachsen auf dem Substrat erhalten werden. Für die Halbleiterschicht 4 eignet sich beispielsweise GaN.

Die Figur 7b zeigt eine Schichtenfolge, welche im Vergleich zur der in Figur 7a dargestellten Schichtenfolge, zusätzlich die erste Passivierungsschicht 3 umfasst, welche auf der Halbleiterschicht 4 angeordnet ist. Für die erste Passivierungsschicht kann beispielsweise SiO₂, SiN oder Al₂O₃ verwendet werden, wobei SiO₂ bevorzugt ist. Das Aufbringen der erste Passivierungsschicht 3 gemäß Teilverfahrensschritt A3), kann beispielsweise mittels PECVD (plasma enhanced chemical vapour deposition) auf die Halbleiterschicht 4 erfolgen. Die Schichtdicke der ersten Passivierungsschicht 3 kann beispielsweise 450 nm betragen.

Figur 7c zeigt im Querschnitt eine Schichtenanordnung nach dem Teilverfahrensschritt A4), dem Aufbringen einer metallischen Spiegelschicht 2. Die metallische Spiegelschicht 2 ist auf der ersten Passivierungsschicht 3 angeordnet. Für die metallische Spiegelschicht 2 eignet sich beispielsweise A1. Die metallische Spiegelschicht 2 kann beispielsweise über Aufdampfen auf die erste Passivierungsschicht 3 aufgebracht werden.

Die Figur 7d zeigt eine Schichtenfolge die im Vergleich zu der Schichtenfolge wie sie in Figur 7c dargestellt ist, zusätzlich einen Träger 1 umfasst. Der Träger 1 kann beispielsweise Ge umfassen. Das Aufsetzen des Trägers 1 im Teilverfahrensschritt A5) kann beispielsweise durch ein Lötverfahren erfolgen. Der Träger 1 kann aber auch über eine Haftschicht 7 mit der metallischen Spiegelschicht 2 verbunden werden. Der Träger 1 dient zur Stabilisierung der Schichtenfolge. Der Träger 1 kann des Weiteren zur elektrischen Kontaktierung des fertigen Bauelements verwendet werden.

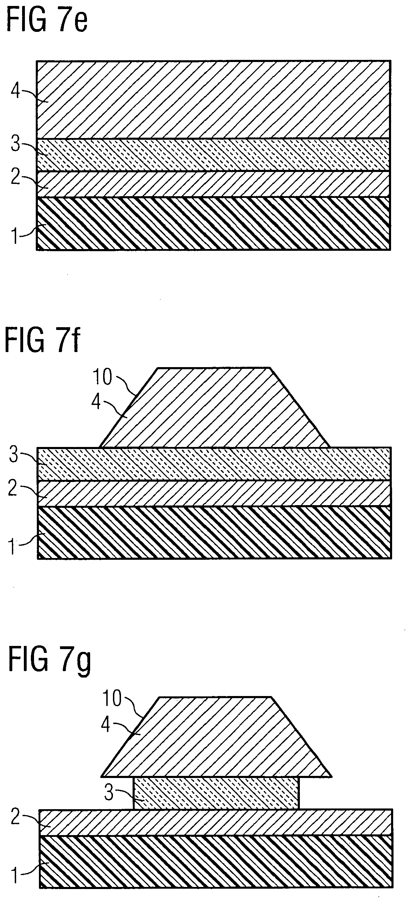

Die Figur 7e zeigt eine Schichtenfolge, wie sie beispielsweise aus der Schichtenfolge wie sie in Figur 7d dargestellt ist, hervorgehen könnte. Hierzu wurde das Substrat 9 von der Halbleiterschicht 4 entfernt. Das Ablösen nach Teilverfahrensschritt A6) kann beispielsweise mittels Laser-Lift-Off erfolgen.

Figur 7f zeigt eine Schichtenfolge, wie sie beispielsweise aus der Schichtenfolge hervorgehen könnte wie sie in Figur 7e dargestellt ist. Hierzu wurde in einem weiteren Verfahrensschritt, gemäß Teilverfahrensschritt A7), die Halbleiterschicht 4 strukturiert. Die Halbleiterschicht 4 weist nun seitliche Mesaflanken 10 auf. Das Strukturieren der Halbleiterschicht 4 kann beispielsweise über einen Ätzschritt erfolgen. Für den Ätzschritt kann beispielsweise ein trockenchemisches Ätzen wie RIE (reactive ion etching) verwendet werden.

Figur 7g zeigt eine Schichtenfolge, wie sie beispielsweise aus der Schichtenfolge hervorgehen könnte wie sie in Figur 7f dargestellt ist. Hierzu wurde im Verfahrensschritt B) ein Teil der ersten Passivierungsschicht 3 entfernt. Hierbei wurde der gesamte Teil, der ersten Passivierungsschicht 3 entfern, welcher nicht in direkten Kontakt mit der Halbleiterschicht 4 gewesen ist. Des Weiteren wurde zusätzlich ein Teil der ersten Passivierungsschicht 3 entfernt, welcher zuvor in direkten Kontakt mit der Halbleiterschicht 4 gewesen ist, so dass die Halbleiterschicht 4 in Bezug auf die erste Passivierungsschicht 3 jetzt überhängende Kanten aufweist. Der Überhang kann beispielsweise 1 µm betragen. Das teilweise Entfernen der ersten Passivierungsschicht 3 kann beispielsweise mittels eines Ätzverfahrens erfolgen. Für den Fall, dass die erste Passivierungsschicht 3 SiO₂ umfasst eignet sich eine gepufferte Flußsäure als Ätzlösung. Die metallische Spielegelschicht 2 wird bei dem Ätzvorgang nicht angegriffen. Die Ätzlösung kann nach Ablauf der Einwirkzeit durch Spülen mit beispielsweise deionisiertem Wasser einfach wieder entfernt werden.

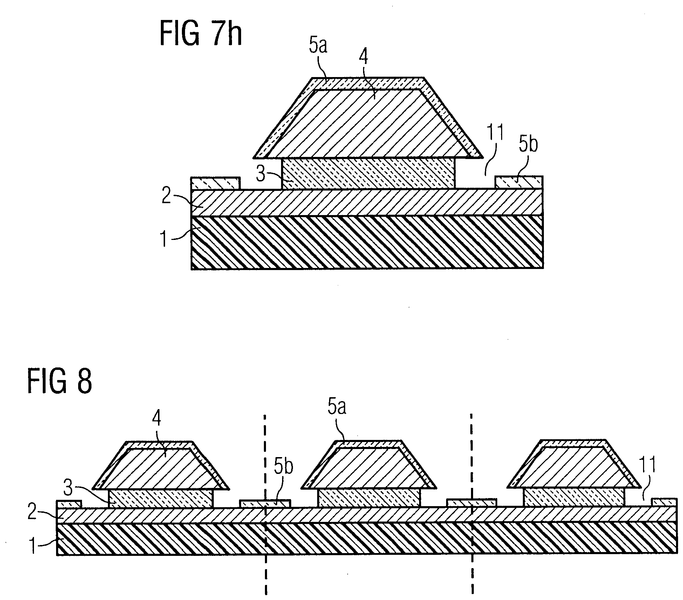

Figur 7h zeigt die Schichtenfolge eines optoelektronischen Bauelements, welche der Schichtenfolge des optoelektronischen Bauelements entspricht, wie es in Figur 1 dargestellt ist. Das in Figur 7h dargestellte Bauelement könnte beispielsweise aus dem in Figur 7g dargestellten Bauelement hervorgehen. Hierzu würde im Verfahrensschritt C) über die Oberfläche des optoelektronischen Bauelements eine zweite Passivierungsschicht 5 aufgetragen worden sein. Durch die überhängenden Kanten der Halbleiterschicht 4 bezüglich der ersten Passivierungsschicht 3 würde hierbei an den überhängenden Kanten der Halbleiterschicht 4 die zweite Passivierungsschicht 5 abreißen, so dass sich zwei Bereiche ausbilden. Ein erster Bereich 5a der zweiten Passivierungsschicht, welcher auf der Oberfläche der Halbleiterschicht 4 und auf den Mesaflanken der Halbleiterschicht angeordnet ist, sowie ein zweiter Bereich 5b der zweiten Passivierungsschicht, welcher auf der metallischen Spiegelschicht 2 angeordnet ist. Das Aufbringen der zweiten Passivierungsschicht 5 kann hierbei beispielsweise über PECVD (plasma enhanced chemical vapour deposition) erfolgen. Für die zweite Passivierungsschicht eignen sich beispielsweise SiO₂, SiN oder Al₂O₃. SiO₂ ist sowohl für die erste Passivierungsschicht wie auch für die zweite Passivierungsschicht das bevorzugte Material.

Figur 8 zeigt in einer schematischen Seitenansicht drei Bauelemente, welche noch nicht vereinzelt wurden. Diese Bauelemente entsprechend nach der Vereinzelung dem Bauelement, welches in Figur 7h dargestellt ist. Aus Gründen der Übersicht wurden exemplarisch nur drei zusammenhängende Bauelemente dargestellt. Die Anzahl der Bauelemente, welche vor dem Vereinzeln zusammenhängend vorliegen, kann deutlich über drei liegen. Durch die beiden gestrichelten Linien in Figur 8 wird angedeutet, wo die Vereinzelung der Bauelemente stattfindet.

Die erste Passivierungsschicht 3 kann auch in weiteren Ausführungsformen des Herstellungsverfahrens strukturiert werden, so dass die metallische Spiegelschicht 2 und die Halbleiterschicht 4 im direkten elektrisch leitenden Kontakt zu einander stehen.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn diese Merkmal oder diese Kombination selbst nicht explizit in den Patentansprüchen oder Ausführungsbeispielen angegeben ist.

## Patentansprüche

1. Optoelektronisches Bauelement, umfassend
- einen Träger (1),
- eine metallische Spiegelschicht (2) angeordnet auf dem Träger (1),
- eine erste Passivierungsschicht (3) angeordnet auf einem Bereich der metallischen Spiegelschicht (2),
- eine Halbleiterschicht (4) zur Erzeugung einer im elektrischen Betrieb aktiven Zone, angeordnet auf der ersten Passivierungsschicht (3),
- eine zweite Passivierungsschicht (5) umfassend zwei Bereiche, wobei der erste Bereich (5a) auf der Oberseite der Halbleiterschicht (4) angeordnet ist, und der zweite Bereich (5b) auf der metallischen Spiegelschicht (2) angeordnet ist, welcher frei von der Halbleiterschicht (4) ist,
wobei der erste Bereich (5a) und der zweite Bereich (5b) der zweiten Passivierungsschicht (5) durch einen um die erste Passivierungsschicht (3) umlaufenden Bereich (11), der frei von der zweiten Passivierungsschicht (5) ist, voneinander getrennt sind.

2. Optoelektronisches Bauelement nach Anspruch 1,
wobei die erste Passivierungsschicht (3) und die zweite Passivierungsschicht (5) räumlich voneinander getrennt angeordnet sind.

3. Optoelektronisches Bauelement nach einem der vorhergehenden Ansprüche,
wobei die Halbleiterschicht (4) im Bezug auf die erste Passivierungsschicht (3) überhängende Kanten aufweist.

4. Optoelektronisches Bauelement nach Anspruch 3,
wobei die erste Passivierungsschicht (3) im Bereich der überhängenden Kanten unterbrochen ist, so dass ein Bereich (11) ausgebildet ist, der frei von der ersten Passivierungsschicht (3) ist.

5. Optoelektronisches Bauelement nach einem der vorhergehenden Ansprüche,
wobei die Halbleiterschicht (4) seitliche Mesaflanken (10) aufweist.

6. Optoelektronisches Bauelement nach einem der vorhergehenden Ansprüche,
wobei das Bauelement als Dünnfilm-LED-Chip ausgeformt ist.

7. Verfahren zur Herstellung eines optoelektronischen Bauelements, umfassend die Verfahrensschritte:
A) Bereitstellen einer Schichtenanordnung umfassend einen Träger (1), eine metallische Spiegelschicht (2), eine erste Passivierungsschicht (3) und eine Hableiterschicht (4),
B) Entfernen eines Teils der ersten Passivierungsschicht (3),
C) Aufbringen einer zweiten Passivierungsschicht (5) auf der Oberseite der Halbleiterschicht (4) und auf der metallischen Spiegelschicht (2), wobei ein erster Bereich (5a) der zweiten Passivierungsschicht (5) auf der Oberseite der Halbleiterschicht und ein zweiter Bereich (5b) der zweiten Passivierungsschicht (5) auf der Spiegelschicht erzeugt wird, und ein um die erste Passivierungsschicht (3) umlaufender Bereich (11), der frei von der zweiten Passivierungsschicht (5) ist und den ersten Bereich (5a) und den zweiten Bereich (5b) voneinander trennt, ausgebildet wird.

8. Verfahren nach Anspruch 7,
wobei der Verfahrenschritt A) folgende Teilverfahrensschritte umfasst:
A1) Bereitstellen eines Substrates (9),
A2) Aufwachsen einer Hableiterschicht (4), zur Erzeugung einer im elektrischen Betrieb aktiven Zone auf dem Substrat (9),
A3) Aufbringen einer ersten Passivierungsschicht (3) auf die Halbleiterschicht (4),
A4) Aufbringen einer metallischen Spiegelschicht (2) auf die erste Passivierungsschicht (3),
A5) Aufsetzen eines Trägers (1) auf die metallische Spiegelschicht (2),
A6) Ablösen des Substrates (9) von der Halbleiterschicht (4),
A7) Strukturieren der Halbleiterschicht (4).

9. Verfahren nach Anspruch 8,
wobei durch das Strukturieren im Verfahrensschritt A7) in der Halbleiterschicht (4) eine Mesa ausgebildet wird, und die Halbleiterschicht (4) nach dem Strukturieren seitliche Mesaflanken (10) aufweist.

10. Verfahren nach einem der Ansprüche 7 bis 9,
wobei das Aufbringen der zweiten Passivierungsschicht (5) im Verfahrensschritt C) so erfolgt, dass die erste Passivierungsschicht (3) und die zweite Passivierungsschicht (5) räumlich voneinander getrennt sind.

11. Verfahren nach einem der Ansprüche 7 bis 10,
wobei die erste Passivierungsschicht (3) im Verfahrensschritt B) so entfernt wird, dass in der Halbleiterschicht (4) im Bezug auf die erste Passivierungsschicht (3) überhängende Kanten erzeugt werden.

12. Verfahren nach einem der Ansprüche 7 bis 11,
wobei im Verfahrensschritt B) ein nasschemisches Verfahren verwendet wird.

13. Verfahren nach Anspruch 12,
wobei das nasschemische Verfahren zum Entfernen eines Teils der ersten Passivierungsschicht (3) verwendet wird, welcher unterhalb der strukturierten Halbleiterschicht (4) angeordnet ist.

14. Verfahren nach einem der Ansprüche 8 bis 13,
wobei im Verfahrensschritt B) die gesamte erste Passivierungsschicht (3) entfernt wird, welche bei der Strukturierung der Hableiterschicht (4) im Verfahrensschritt A7) freigelegt wurde.

15. Verfahren nach Anspruch 11,
wobei das Aufbringen der zweiten Passivierungsschicht (5) im Verfahrensschritt C) großflächig erfolgt, wobei der großflächige Film an den überhängenden Kanten abreißt, wodurch der erste Bereich (5a) und der zweite Bereich (5b) der zweiten Passivierungsschicht ausgebildet werden.

## Claims

1. An optoelectronic component comprising
- a carrier (1),
- a metallic mirror layer (2), which is arranged on the carrier (1),
- a first passivation layer (3), which is arranged on a region of the metallic mirror layer (2),
- a semiconductor layer (4) for producing a zone active during electrical operation, which is arranged on the first passivation layer (3),
- a second passivation layer (5) comprising two regions, wherein the first region (5a) is arranged on the upper side of the semiconductor layer (4), and the second region (5b) is arranged on the metallic mirror layer (2) and is free of the semiconductor layer (4),
wherein the first region (5a) and the second region (5b) of the second passivation layer (5) are separated from one another by a region (11) which surrounds the first passivation layer (3) and is free of the second passivation layer (5).

2. The optoelectronic component according to claim 1,
wherein the first passivation layer (3) and the second passivation layer (5) are arranged spatially separated from one another.

3. The optoelectronic component according to one of the preceding claims,
wherein the semiconductor layer (4) has overhanging edges with respect to the first passivation layer (3).

4. The optoelectronic component according to claim 3,
wherein the first passivation layer (3) is interrupted in the region of the overhanging edges such that a region (11) is formed which is free of the first passivation layer (3).

5. The optoelectronic component according to one of the preceding claims,
wherein the semiconductor layer (4) has lateral mesa flanks (10).

6. The optoelectronic component according to one of the preceding claims,
wherein the component is formed as a thin-film LED chip.

7. A method for producing an optoelectronic component, comprising the method steps:
A) Provision of a layer arrangement comprising a carrier (1), a metallic mirror layer (2), a first passivation layer (3) and a semiconductor layer (4),
B) Removing a part of the first passivation layer (3),
C) Application of a second passivation layer (5) on the top side of the semiconductor layer (4) and on the metallic mirror layer (2), wherein a first region (5a) of the second passivation layer (5) is generated on the top side of the semiconductor layer and a second region (5b) of the second passivation layer (5) is generated on the mirror layer,
and a region (11) surrounding the first passivation layer (3) is generated, said region being free of the second passivation layer (5) and separating the first region (5a) and the second region (5b) from one another.

8. The method according to claim 7,
wherein method step A) comprises the following partial method steps:
A1) Provision of a substrate (9),
A2) Growth of a semiconductor layer (4), for producing a zone active during electrical operation on the substrate (9),
A3) Applying a first passivation layer (3) on the semiconductor layer (4),
A4) Applying a metallic mirror layer (2) to the first passivation layer (3),
A5) Placing a carrier (1) onto the metallic mirror layer (2),
A6) Detaching the substrate (9) from the semiconductor layer (4),
A7) Structuring of the semiconductor layer (4).

9. The method according to claim 8,
wherein a mesa is formed in the semiconductor layer (4) by means of the structuring in method step A7), and the semiconductor layer (4) comprises lateral mesa flanks (10) after the structuring.

10. The method according to one of claims 7 to 9,
wherein the application of the second passivation layer (5) in method step C) is carried out in such a way that the first passivation layer (3) and the second passivation layer (5) are spatially separated from one another.

11. The method according to one of claims 7 to 10,
wherein the first passivation layer (3) is removed in method step B) in such a way that overhanging edges are produced in the semiconductor layer (4) with respect to the first passivation layer (3).

12. The method according to one of claims 7 to 11,
wherein a wet-chemical method is used in method step B).

13. The method according to claim 12,
wherein the wet-chemical method is used for removing a part of the first passivation layer (3) which is arranged below the structured semiconductor layer (4).

14. The method according to one of claims 8 to 13,
wherein in method step B) the entire first passivation layer (3) is removed, which has been exposed during the structuring of the semiconductor layer (4) in method step A7).

15. The method according to claim 11,
wherein the application of the second passivation layer (5) in method step C) is done over a large area, wherein the large-area film tears off at the overhanging edges, as a result of which the first region (5a) and the second region (5b) of the second passivation layer are formed.

## Revendications

1. Composant optoélectronique comprenant
- un support (1)
- une couche réfléchissante (2) métallique, disposée sur le support (1),
- une première couche de passivation (3) disposée sur une zone de la couche réfléchissante (2) métallique,
- une couche à semi-conducteur (4) destinée à générer une zone active pendant le fonctionnement électrique, disposée sur la première couche de passivation (3),
- une deuxième couche de passivation (5) comprenant deux zones, la première zone (5a) étant disposée sur le côté supérieur de la couche à semi-conducteur (4), et la deuxième zone (5b) étant disposée sur la couche réfléchissante (2) métallique, laquelle est exempte de la couche à semi-conducteur (4),
- la première zone (5a) et la deuxième zone (5b) de la deuxième couche de passivation (5) étant séparées l'une de l'autre par une zone (11) entourant la première couche de passivation (3), laquelle zone est exempte de la deuxième couche de passivation (5).

2. Composant optoélectronique selon la revendication 1,
la première couche de passivation (3) et la deuxième couche de passivation (5) étant disposées de manière spatialement séparée l'une de l'autre.

3. Composant optoélectronique selon l'une quelconque des revendications précédentes,
la couche à semi-conducteur (4) présentant des arêtes en surplomb par rapport à la première couche de passivation (3) .

4. Composant optoélectronique selon la revendication 3,
la première couche de passivation (3) étant interrompue dans la zone des arêtes en surplomb, de sorte qu'une zone (11) est réalisée, laquelle est exempte de la première couche de passivation (3).

5. Composant optoélectronique selon l'une quelconque des revendications précédentes,
la couche à semi-conducteur (4) présentant des flancs mésa (10) latéraux.

6. Composant optoélectronique selon l'une quelconque des revendications précédentes,
le composant étant conçu comme puce à LED à couche mince.

7. Procédé de fabrication d'un composant optoélectronique, comprenant les étapes de procédé :
A) fourniture d'un agencement de couches comprenant un support (1), une couche réfléchissante (2) métallique, une première couche de passivation (3) et une couche à semi-conducteur (4),
B) enlèvement d'une zone de la première couche de passivation (3),
C) application d'une deuxième couche de passivation (5) sur le côté supérieur de la couche à semi-conducteur (4) et sur la couche réfléchissante (2) métallique, une première zone (5a) de la deuxième couche de passivation (5) étant générée sur le côté supérieur de la couche à semi-conducteur et une deuxième zone (5b) de la deuxième couche de passivation (5) étant générée sur la couche réfléchissante, et une zone (11) entourant la première couche de passivation (3) étant formée, laquelle zone est exempte de la deuxième couche de passivation (5) et sépare l'une de l'autre la première zone (5a) de la deuxième zone (5b) .

8. Procédé selon la revendication 7,
dans lequel l'étape de procédé A) comprend les étapes de procédé partielles suivantes :
A1) fourniture d'un substrat (9),
A2) croissance d'une couche à semi-conducteur (4) destinée à générer sur le substrat (9) d'une zone active pendant le fonctionnement électrique,
A3) application d'une première couche de passivation (3) sur la couche à semi-conducteur (4),
A4) application d'une couche réfléchissante (2) métallique sur la première couche de passivation (3), A5) pose d'un support (1) sur la couche réfléchissante (2) métallique,
A6) enlèvement du substrat (9) de la couche à semi-conducteur (4),
A7) structuration de la couche à semi-conducteur (4).

9. Procédé selon la revendication 8,
dans lequel une mésa est formée dans la couche à semi-conducteur (4) en raison de la structuration à l'étape de procédé A7), et dans lequel la couche à semi-conducteur (4) présente des flancs mésa (10) latéraux après la structuration.

10. Procédé selon l'une quelconque des revendications 7 à 9,
dans lequel l'application de la deuxième couche de passivation (5) à l'étape de procédé C) est réalisée de manière à ce que la première couche de passivation (3) et la deuxième couche de passivation (5) soient spatialement séparées l'une de l'autre.

11. Procédé selon l'une quelconque des revendications 7 à 10,
dans lequel la première couche de passivation (3) à l'étape de procédé B) est enlevée de manière à ce que des arêtes en surplomb par rapport à la première couche de passivation (3) sont générées dans la couche à semi-conducteur (4).

12. Procédé selon l'une quelconque des revendications 7 à 11,
dans lequel un procédé par voie chimique humide est utilisé à l'étape de procédé B).

13. Procédé selon la revendication 12,
dans lequel le procédé par voie chimique humide est utilisé pour enlever une partie de la première couche de passivation (3), laquelle est disposée en dessous de la couche à semi-conducteur (4) structurée.

14. Procédé selon l'une quelconque des revendications 8 à 13, la totalité de la première couche de passivation (3) étant enlevée à l'étape de procédé B), laquelle a été exposée lors de la structuration de la couche à semi-conducteur (4) à l'étape de procédé A7).

15. Procédé selon la revendication 11,
dans lequel l'application de la deuxième couche de passivation (5) à l'étape de procédé C) est réalisée sur une grande surface, le film à grande surface se déchirant sur les flancs en surplomb, sur quoi la première zone (5a) et la deuxième zone (5b) de la deuxième couche de passivation sont formées.
